# EUROPÄISCHE PATENTSCHRIFT

(11) **EP 2 614 691 B1**
(45) Veröffentlichungstag und Bekanntmachung des Hinweises auf die Patenterteilung: **07.11.2018**
(21) Anmeldenummer: 11757247.9
(22) Anmeldetag: 06.09.2011
(51) Int. Cl.: H05K 1/02, H05K 3/22

(54) **LEITERPLATTE ZUM BESTÜCKEN MIT LEUCHTKÖRPERN**
PRINTED CIRCUIT BOARD FOR POPULATION WITH LUMINOUS BODIES
CARTE DE CIRCUIT IMPRIMÉ POUR LE MONTAGE DE CORPS LUMINEUX

(30) Priorität: 08.09.2010 DE 202010008479 U
(43) Veröffentlichungstag der Anmeldung: 17.07.2013
(73) Patentinhaber: Zumtobel Lighting GmbH, 6850 Dornbirn (AT)
(72) Erfinder: OLARIU, Cristian, A-6850 Dornbirn (AT); BLOCK, Steffen, A-6850 Dornbirn (AT)
(74) Vertreter: Thun, Clemens
(86) Internationale Anmeldenummer: PCT/EP2011/065413
(87) Internationale Veröffentlichungsnummer: WO 2012/032062

(56) Entgegenhaltungen:
- EP-A1- 2 039 990
- DE-A1- 4 418 299
- US-A1- 2007 242 441
- US-A1- 2009 141 493

## Beschreibung

Die vorliegende Erfindung betrifft eine Leiterplatte zum Bestücken mit Leuchtkörpern, insbesondere LEDs, wobei die Leiterplatte mindestens einen Bestückungsbereich für Leuchtkörper aufweist.

Bei elektronischen Geräten bei denen mehrere LEDs Anwendung finden, kommen häufig Leiterplatten bzw. Platinen zum Einsatz, auf denen die LEDs angeordnet sind. Hierbei ist es bisher erforderlich, dass für jedes neue elektronische Gerät bzw. jede neue Anwendung eine neue Leiterplatte entwickelt und hergestellt wird, da es zum einen eine Vielzahl unterschiedlicher LED-Typen gibt, die sich beispielsweise in ihren Bauformen und Anschlussmöglichkeiten unterscheiden, und zum anderen selten das gleiche Muster bzw. der gleiche Abstand für verschiedene Geräte bzw. Anwendungen benötigt wird.

Durch die jeweils erforderliche Neuentwicklung einer Leiterplatte, auf der mehrere LEDs angebracht werden können, ergibt sich eine Reihe von Nachteilen. Zum einen besteht die Problematik, dass erst während der Entwicklung eines neuen Geräts bzw. einer neuen Anwendung die genaue Positionierung der LEDs bekannt wird, wodurch erst dann mit der Entwicklung der entsprechenden Leiterplatte begonnen werden kann, wodurch sich entsprechend längere Lieferzeiten ergeben können. Zum anderen führen auch die unter Umständen geringen Stückzahlen und die jeweils neu erforderliche Entwicklung eines Layouts für die Leiterplatte zu höheren Kosten.

Relevanter Stand der Technik ist in den Dokumenten US 2007/242441 A1, EP 2 039 990 A1, US 2009/141493 A1 und DE 44 18 299 A1 offenbart.

Aufgabe der vorliegenden Erfindung ist es somit, eine Leiterplatte zum Bestücken mit Leuchtkörpern zu entwickeln, die in unterschiedlichen Geräten und bei unterschiedlichen Anwendungen zum Einsatz kommen kann und eine hohe Flexibilität bei den Einsatzmöglichkeiten aufweist.

Die Aufgabe wird durch eine Leiterplatte zum Bestücken mit Leuchtkörpern gemäß dem Anspruch 1 gelöst. Vorteilhafte Weiterbildungen der Erfindung sind Gegenstand der abhängigen Ansprüche.

Erfindungsgemäß wird eine Leiterplatte zum Bestücken mit Leuchtkörpern, insbesondere LEDs vorgeschlagen, die mehrere Bestückungsbereiche für Leuchtkörper aufweist, wobei jeder Bestückungsbereich mindestens zwei Anschlussmöglichkeiten für Leuchtkörper unterschiedlicher Bauform oder unterschiedlicher Type aufweist.

Erfindungsgemäß sind die mehreren Bestückungsbereiche so auf der Leiterplatte angeordnet, dass sie mehrere Muster ergeben, wobei in einem Muster jeweils die Bestückungsbereiche den gleichen Abstand zueinander aufweisen. Vorzugsweise können die Anschlussmöglichkeiten innerhalb des Bestückungsbereichs jeweils seitlich nebeneinander oder kreisförmig angeordnet sein. Zusätzlich kann der Bestückungsbereich auch weitere Anschlussmöglichkeiten für eine Überbrückungseinheit, insbesondere einen 0-Ohm Widerstand, aufweisen, wobei diese weiteren Anschlussmöglichkeiten in dem Bestückungsbereich derart positioniert sein können, dass die in den Anschlussmöglichkeiten für Leuchtkörper angeordneten Leuchtkörper mit einer Optik versehbar sind.

Erfindungsgemäß sind alle Bestückungsbereiche der Leiterplatte in Serie miteinander verbunden. Des Weiteren kann vorgesehen sein, dass die Leiterplatte an ihren Endbereichen Schneid-Klemm-Kontakte bzw. Klemmkontakte und/oder Lötstellen zur Anbringung einer Verkabelung und Anschlussmöglichkeiten für einen NTC-Widerstand aufweist.

Erfindungsgemäß wird auch ein Leuchtmodul vorgeschlagen, das mindestens zwei erfindungsgemäße Leiterplatten zum Bestücken mit Leuchtkörpern aufweist, wobei die Leiterplatten miteinander verbunden sind.

Durch die erfindungsgemäße Ausgestaltung der Leiterplatte ist es nunmehr möglich, dass Leuchtkörper bzw. LEDs unterschiedlicher Hersteller oder unterschiedlicher Typen auf ein und derselben Leiterplatte eingesetzt werden können und bei einem Wechsel des LED-Typs kein Neuentwurf der Leiterplatte erforderlich ist. Zusätzlich ergibt sich durch die Anordnung der Bestückungsbereiche in mehreren Mustern die Möglichkeit, die LEDs je nach gewünschter Anwendung unterschiedlich zu positionieren, wodurch nicht für jede Anwendung bzw. für jedes Gerät ein Neuentwurf einer Leiterplatte notwendig ist.

Nachfolgend soll die Erfindung anhand von Ausführungsbeispielen und den beiliegenden Zeichnungen näher erläutert werden. Es zeigen:
- Figur 1: eine Leiterplatte mit einem Bestückungsbereich;
- Figur 2: eine erfindungsgemäße Leiterplatte mit mehreren Bestückungsbereichen;
- Figur 3: eine erfindungsgemäße Leiterplatte mit mehreren Bestückungsbereichen.

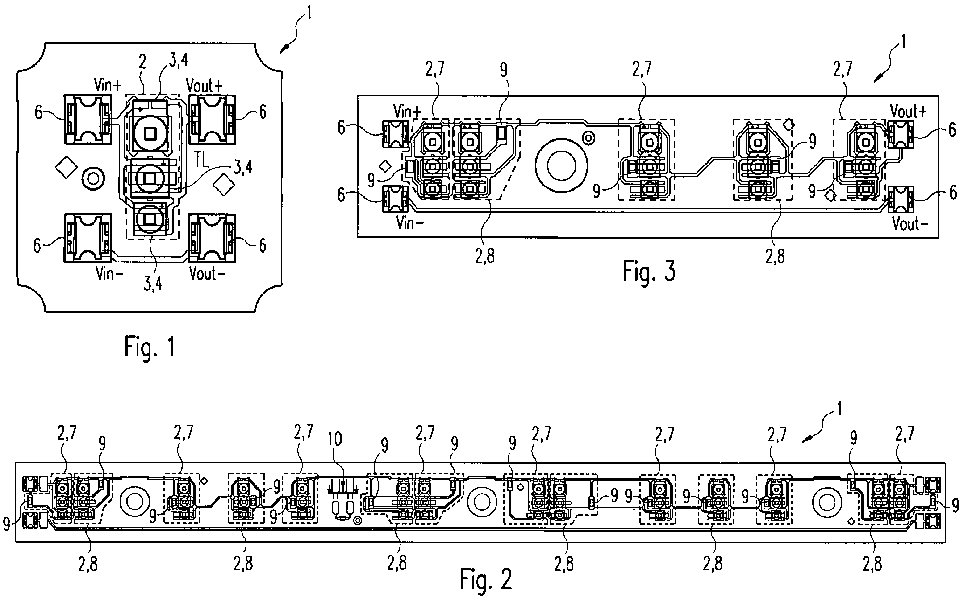

In Figur 1 ist eine Leiterplatte 1 zum Bestücken mit Leuchtkörpern bzw. LEDs als Beispiel gezeigt, um das Verständnis der Erfindung zu erleichtern. Die Leiterplatte 1 weist einen Bestückungsbereich 2 auf, innerhalb dessen eine LED 4 angebracht werden kann. Im Bestückungsbereich 2 sind hierfür drei Anschlussmöglichkeiten 3 angeordnet, wobei jede Anschlussmöglichkeit 3 jeweils für einen anderen LED-Typ ausgelegt ist. So können die Anschlussmöglichkeiten 3 beispielsweise derart ausgelegt sein, dass an einer ersten Anschlussmöglichkeit LEDs der Firma Philips (zum Beispiel Rebel) an einer zweiten Anschlussmöglichkeit LEDs der Firma Osram (zum Beispiel Oslon SSL) und an einer dritten Anschlussmöglichkeit LEDs der Firma Cree (zum Beispiel XP-x) angebracht werden können, wobei jedoch die Erfindung nicht auf diese LED-Typen bzw.

Hersteller beschränkt ist. In Figur 1 sind nur beispielhaft an allen Anschlussmöglichkeiten 3 LEDs 4 vorgesehen. Bei der normalen Verwendung der Leiterplatte 1 wird jedoch jeweils nur ein Typ bestückt, die anderen Anschlussmöglichkeiten 3 bleiben frei.

Die Anschlussmöglichkeiten 3 sind auf der Leiterplatte 1 seitlich nebeneinander bzw. parallel angeordnet, wobei die drei Anschlussmöglichkeiten 3 derart an die Stromversorgung angeschlossen sind, dass, sobald eine der drei Anschlussmöglichkeiten 3 mit einer LED 4 bestück ist, der Stromkreis durch diese LED 4 geschlossen ist. Die Anschlussmöglichkeiten 3 sind somit parallel zueinander an die Stromversorgung angeschlossen.

Für den Anschluss der Stromversorgung weist die Leiterplatte 1 Schneid-Klemm-Kontakte 6 bzw. Klemmkontakte auf, an die die Verkabelung einer Stromversorgung angeschlossen werden kann. Eine weitere Möglichkeit besteht darin, dass die Stromversorgung an auf der Leiterplatte 1 angeordneten Lötstellen angeschlossen wird.

Durch die besondere Ausgestaltung der Bestückungsbereiche 2 mit mehreren Anschlussmöglichkeiten 3, ist es nunmehr möglich, dass die Leiterplatte 1 deutlich flexibler in ihren Einsatzmöglichkeiten ist, da LEDs verschiedener Hersteller bzw. verschiedene LED-Typen auf der Leiterplatte 1 angebracht werden können und nicht für jeden LED-Typ eine eigene Leiterplatte geschaffen werden muss.

In Figur 1 ist die Leiterplatte 1 als linearrechteckige Leiterplatte ausgeführt, die in einer entsprechenden Vorrichtung vorzugweise um einen Versatz nach oben bzw. nach unten verschoben werden kann, damit der Lichtpunkt bzw. die Einkopplung immer zentriert erfolgt. Anstatt einer linearrechteckigen Leiterplatte 1 wie in Figur 1 gezeigt, können auch runde Leiterplatten zum Einsatz kommen, bei denen dann jedoch die Anschlussmöglichkeiten innerhalb eines Bestückungsbereichs nicht mehr seitlich nebeneinander bzw. parallel sondern in Serie in Kreisen angeordnet sind, wobei dann zusätzlich jede Anschlussmöglichkeit die Möglichkeit aufweist, eine Überbrückungseinheit, beispielsweise einen 0-Ohm Widerstand, aufzunehmen um bei Nichtbestückung überbrückt werden zu können.

Figur 2 zeigt eine erfindungsgemäße Leiterplatte 1 zum Bestücken mit Leuchtkörpern insbesondere LEDs, die mehrere Bestückungsbereiche 2 aufweist. Die Bestückungsbereiche 2 sind hierbei derart auf der Leiterplatte 1 angeordnet, dass sie mehrere Muster ergeben, wobei in einem Muster jeweils die Bestückungsbereiche 2 den gleichen Abstand zueinander aufweisen. So sind im Einzelnen auf der Leiterplatte 1 acht Bestückungsbereiche 7 vorgesehen, die jeweils den gleichen Abstand zueinander aufweisen. Zusätzlich weist die Leiterplatte 1 noch sechs Bestückungsbereiche 8 auf. Je nachdem was für ein Muster für die entsprechende Anwendung bzw. für das entsprechende Gerät gewünscht ist, werden nun die Bestückungsbereiche 7 oder die Bestückungsbereiche 8 mit LEDs bestückt. Hierdurch ergibt sich bei der in Figur 2 gezeigten Ausführung der erfindungsgemäßen Leiterplatte 1 entweder ein Muster mit acht LEDs (Bestückungsbereiche 7 mit LEDs bestückt) oder ein Muster mit sechs LEDs (Bestückungsbereiche 8 mit LEDs bestückt). Selbstverständlich wäre es natürlich auch denkbar, bei den verschiedenen Bestückungsmustern jeweils nur einen Teil der Bestückungsbereiche zu nutzen. Möglich wäre z.B., lediglich jeden zweiten Bestückungsbereich zu nutzen, so dass dann letztendlich gleichmäßig verteilte Anordnungen mit vier bzw. drei LEDs erhalten werden.

Durch diese flexible Ausgestaltung der erfindungsgemäßen Leiterplatte 1 ergibt sich nun der Vorteil, dass die Leiterplatte 1 nicht mehr nur für eine Anwendung bzw. für ein Gerät benutzt werden kann, sondern für eine Vielzahl von Anwendungen bzw. Geräten, wodurch sich die Entwicklung jeweils einer neueren Leiterplatte für eine Anwendung einsparen lässt.

Die Bestückungsbereiche 2 der Leiterplatte 1 in Figur 2 entsprechen im Wesentlichen dem Bestückungsbereich 2 der Leiterplatte 1 in Figur 1 und weisen dementsprechend ebenfalls drei Anschlussmöglichkeiten 3 für verschiedene LEDs 4 auf. Zusätzlich jedoch umfasst jeder Bestückungsbereich 2 noch eine weitere Anschlussmöglichkeit 9 für eine Überbrückungseinheit, beispielsweise einen 0-Ohm Wiederstand oder eine einfache Drahtbrücke. Diese Überbrückungseinheit ist erforderlich, da die Bestückungsbereiche 2 auf der Leiterplatte 1 von Figur 2 in Reihe bzw. Serie geschaltet sind. Wenn nun beispielsweise nur die Bestückungsbereiche 7 mit LEDs bestückt sind, ist es erforderlich, dass die Bestückungsbereiche 8 eine entsprechende Überbrückungseinheit an den weiteren Anschlussmöglichkeiten 9 aufweisen, um die Stromversorgung für alle LEDs in den Bestückungsbereichen 7 zu ermöglichen. Die weiteren Anschlussmöglichkeiten 9 für die Überbrückungseinheiten sind hierbei innerhalb der Bestückungsbereiche 2 derart angeordnet, dass die verwendeten LEDs mit einer Optik versehen werden können, wobei das Anbringen der Optik durch die Überbrückungseinheiten nicht beeinträchtigt wird.

Des Weiteren sind in Figur 2 auf der erfindungsgemäßen Leiterplatte 1 auch Anschlussmöglichkeiten 10 für einen NTC-Widerstand vorgesehen.

In Figur 3 ist eine erfindungsgemäße Leiterplatte 1 gezeigt, die im Vergleich zu Figur 2 weniger Bestückungsbereiche 2 aufweist. Hierbei sind die Bestückungsbereiche 2 auf der Leiterplatte 1 vergleichbar wie auf dem ersten Teilstück der Leiterplatte 1 von Figur 2 angeordnet. Im Einzelnen sind auf der Leiterplatte 1 in Figur 3 drei Bestückungsbereiche 7 angeordnet, die jeweils zueinander den gleichen Abstand wie die Bestückungsbereiche 7 in Figur 2 aufweisen und zwei Bestückungsbereiche 8, die ebenfalls zueinander den gleichen Abstand wie die Bestückungsbereiche 8 in Figur 2 aufweisen. Somit ist es möglich, beispielsweise drei LEDs in den Bestückungsbereichen 7 anzuordnen, die jeweils denselben Abstand zueinander haben. Zusätzlich ist es mit der erfindungsgemäßen Leiterplatte 1 aus Figur 3 ebenfalls möglich zwei LEDs in den Bestückungsbereichen 8 anzuordnen, die ebenfalls denselben Abstand zueinander aufweisen.

Erfindungsgemäß ist auch noch ein Leuchtmodul vorgesehen, dass mehrere der oben beschriebenen Leiterplatten 1 aufweist, die miteinander verbunden sind. Die Verbindung erfolgt hierbei über die Schneid-Klemm-Kontakte 6 bzw. Klemmkontakte um die Stromversorgung zwischen den Leiterplatten zu ermöglichen. Hierbei ist es beispielsweise möglich, dass eine Leiterplatte 1 gemäß Figur 2 eingesetzt wird und mit einer Leiterplatte 1 gemäß Figur 3 verlängert wird, wobei sich die auf der Leiterplatte 1 gemäß Figur 2 ergebenden Muster durch die Leiterplatte 1 gemäß Figur 3 weiter fortsetzen. Der Abstand zwischen dem letzten Bestückungsbereich 7 bzw. 8 der Leiterplatte 1 gemäß Figur 2 und dem ersten Bestückungsbereich 7 bzw. 8 der Leiterplatte 1 gemäß Figur 3 ist also identisch zu den Abständen der jeweiligen Bestückungsbereiche 7 bzw. 8 zueinander auf den Leiterplatten 1 gemäß Figur 2 bzw. 3.

Allgemein können im erfindungsgemäßen Leuchtmodul Leiterplatten unterschiedlicher Länge aneinandergebaut sein, wodurch mit einer sehr geringen Anzahl unterschiedlicher Leiterplattentypen viele verschiedene Längen eines Leuchtmoduls ermöglicht werden und gleichzeitig die Muster (Abstände zwischen den Bestückungsbereichen) immer weiter fortgesetzt werden können.

Zusätzlich besteht auch die Möglichkeit, dass Leiterplatten zusammen in dem Leuchtmodul zum Einsatz kommen, die jeweils einen unterschiedlichen Abstand zwischen den einzelnen LEDs bzw. Bestückungsbereichen aufweisen, wodurch beispielsweise ein Leuchtmodul geschaffen werden kann, dass in einem ersten Teil mit einer ersten Leiterplatte einen etwas größeren LED-Abstand aufweist und in einem zweiten Bereich mit einer zweiten Leiterplatte einen geringeren LED-Abstand.

Die erfindungsgemäße Leiterplatte 1 ist nicht auf die in den Figuren 2 und 3 gezeigten Ausführungsformen beschränkt, sondern kann jede beliebige Länge und eine beliebige Anzahl von Bestückungsbereichen und auch Anschlussmöglichkeiten aufweisen, wobei sich immer eine äußerst flexibel einsetzbare Leiterplatte ergibt, die nicht auf eine Anwendung bzw. auf ein einzelnes Gerät beschränkt ist. Mögliche Längen einer Leiterplatte sind beispielsweise 101 mm, 76 mm oder 25 mm, wobei je nach Wunsch entsprechend viele Bestückungsbereiche vorgesehen sein können.

## Patentansprüche

1. Leiterplatte (1) zum Bestücken mit Leuchtkörpern, insbesondere LEDs (4), mit mehreren Bestückungsbereichen (2, 7, 8) für Leuchtkörper, wobei die Bestückungsbereiche (2, 7, 8) jeweils mindestens zwei parallel zueinander an die Stromversorgung angeschlossene Anschlussmöglichkeiten (3) für Leuchtkörper unterschiedlicher Bauform oder unterschiedlicher Type aufweisen und wobei die mehreren Bestückungsbereiche (2, 7, 8) so auf der Leiterplatte (1) angeordnet sind, dass sie mehrere Muster ergeben, wobei in einem Muster jeweils die Bestückungsbereiche (7, 8) den gleichen Abstand zueinander aufweisen,
**dadurch gekennzeichnet,**
**dass** jeder Bestückungsbereich (2) zusätzlich eine weitere Anschlussmöglichkeit (9) für eine Überbrückungseinheit, insbesondere einen 0-Ohm Widerstand, aufweist und dass alle Bestückungsbereiche (2) der Leiterplatte (1) in Serie miteinander verbunden sind.

2. Leiterplatte nach Anspruch 1,
**dadurch gekennzeichnet,**
**dass** die Anschlussmöglichkeiten (3) innerhalb eines Bestückungsbereichs (2) jeweils seitlich nebeneinander angeordnet sind.

3. Leiterplatte nach Anspruch 1,
**dadurch gekennzeichnet,**
**dass** die Anschlussmöglichkeiten (3) innerhalb eines Bestückungsbereichs (2) kreisförmig angeordnet sind.

4. Leiterplatte nach einem der vorherigen Ansprüche,
**dadurch gekennzeichnet,**
**dass** die weiteren Anschlussmöglichkeiten (9) für eine Überbrückungseinheit derart in den Bestückungsbereichen (2) positioniert sind, dass die in den Anschlussmöglichkeiten (3) für Leuchtkörper angeordneten Leuchtkörper mit einer Optik versehbar sind.

5. Leiterplatte nach einem der vorherigen Ansprüche,
**dadurch gekennzeichnet,**
**dass** die Leiterplatte (1) an ihren Endbereichen Schneid-Klemm-Kontakte (6) und/oder Lötstellen zur Anbringung einer Verkabelung aufweist.

6. Leiterplatte nach einem der vorherigen Ansprüche,
**dadurch gekennzeichnet,**
**dass** die Leiterplatte (1) Anschlussmöglichkeiten (10) für einen NTC-Widerstand aufweist.

7. Leuchtmodul mit mindestens zwei Leiterplatten (1) nach einem der vorherigen Ansprüche, wobei die Leiterplatten (1) miteinander verbunden sind.

## Claims

1. A printed circuit board (1) for population with luminous bodies, particularly LEDs (4) having a plurality of placement regions (2, 7, 8) for luminous bodies, wherein the placement regions (2, 7, 8) have in each case at least two connection possibilities (3) connected to the power supply parallel to one another for luminous bodies of different designs or different types and wherein the plurality of placement regions (2, 7, 8) are arranged on the printed circuit board (1) such that they produce a plurality of patterns, wherein in one pattern, the placement regions (7, 8) in each case have the same distance from one another,
**characterized in**
**that** each placement region (2) additionally has one further connection possibility (9) for a bridging unit, in particular a 0 ohm resistor and that all of the placement regions (2) of the printed circuit board (1) are connected in series with one another.

2. A printed circuit board according to Claim 1
**characterized in**
**that** the connection possibilities (3) are arranged within a placement region (2), in each case laterally side by side.

3. A printed circuit board according to Claim 1,
**characterized in**
**that** the connection possibilities (3) are arranged circularly within a placement region (2).

4. A printed circuit board according to Claim 1,
**characterized in**
**that** the further connection possibilities (9) for a bridging unit are positioned in the placement regions (2) in such a manner that the luminous bodies arranged in the connection possibilities (3) for luminous bodies can be provided with a lens system.

5. A printed circuit board according to any one of the preceding claims,
**characterized in**
**that** the printed circuit board (1) has insulation displacement contacts on its end regions and/or soldering points for applying a cable.

6. A printed circuit board according to any one of the preceding claims,
**characterized in**
**that** the printed circuit board (1) has connection possibilities (10) for a negative temperature coefficient (NTC) resistor.

7. A luminous module having at least two printed circuit boards (1) according to any one of the preceding claims wherein the printed circuit boards (1) are connected with one another.

## Revendications

1. Circuit imprimé (1) destiné à être équipé de luminaires, plus particulièrement de LED (4), avec plusieurs zones de montage (2, 7, 8) pour des luminaires, les zones de montage (2, 7, 8) comprenant chacune au moins deux possibilités de raccordement (3), connectés parallèlement entre eux à l'alimentation électrique, pour des luminaires de différentes formes ou de différents types et les plusieurs zones de montage (2, 7, 8) étant disposées sur le circuit imprimé (1) de façon à obtenir plusieurs motifs, moyennant quoi, dans un motif, les zones de montage (7, 8) présentant la même distance entre eux,
**caractérisé en ce que**
chaque zone de montage (2) comprend en outre une possibilité de raccordement (9) supplémentaire pour une unité de pontage, plus particulièrement une résistance de 0 Ohm, et **en ce que** toutes les zones de montage (2) du circuit imprimé (1) sont branchées entre elles en série.

2. Circuit imprimé selon la revendication 1,
**caractérisé en ce que**
les possibilités de raccordement (3) sont disposées latéralement les unes à côté des autres à l'intérieur d'une zone de montage (2).

3. Circuit imprimé selon la revendication 1,
**caractérisé en ce que**
les possibilités de raccordement (3) sont disposées en forme de cercle à l'intérieur d'une zone de montage (2).

4. Circuit imprimé selon l'une des revendications précédentes
**caractérisé en ce que**
les possibilités de raccordement (9) supplémentaires pour une unité de pontage sont positionnées dans les zones de montage (2) de façon à ce que les luminaires disposés dans les possibilités de raccordement (3) pour les luminaires puissent être équipés d'une optique.

5. Circuit imprimé selon l'une des revendications précédentes
**caractérisé en ce que**
le circuit imprimé (1) comprend, au niveau de ses zones d'extrémité, des contacts auto-dénudants (6) et/ou des points de brasage pour le montage d'un câblage.

6. Circuit imprimé selon l'une des revendications précédentes
**caractérisé en ce que**
le circuit imprimé (1) comprend des possibilités de raccordement (10) pour une résistance NTC.

7. Module d'éclairage avec au moins deux circuits imprimés (1) selon l'une des revendications précédentes, les circuits imprimés (1) étant reliés entre eux.
